(19) Europäisches Patentamt / European Patent Office / Office européen des brevets

(11) **EP 2 942 333 B1**

(12) **EUROPÄISCHE PATENTSCHRIFT**

(45) Veröffentlichungstag und Bekanntmachung des Hinweises auf die Patenterteilung:
**28.06.2017 Patentblatt 2017/26**

(51) Int Cl.:
*C03C 17/00* (2006.01)    *C03C 17/22* (2006.01)
*C03C 17/34* (2006.01)

(21) Anmeldenummer: **15160968.2**

(22) Anmeldetag: **26.03.2015**

(54) **KRATZRESISTENTE BESCHICHTUNGEN, SUBSTRATE MIT KRATZFESTEN BESCHICHTUNGEN UND VERFAHREN ZU DEREN HERSTELLUNG**

SCRATCH RESISTANT COATINGS, SUBSTRATES WITH SCRATCH-RESISTANT COATINGS AND METHOD FOR PRODUCING THE SAME

REVÊTEMENTS ANTI-RAYURES, SUBSTRATS DOTÉS DE REVÊTEMENTS ANTI-RAYURES ET LEUR PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.04.2014 DE 102014104799**

(43) Veröffentlichungstag der Anmeldung:
**11.11.2015 Patentblatt 2015/46**

(73) Patentinhaber: **Schott AG**
**55122 Mainz (DE)**

(72) Erfinder:
• Henn, Christian
  **55546 Frei-Laubersheim (DE)**
• Damm, Thorsten
  **55268 Nieder-Olm (DE)**

(74) Vertreter: **Blumbach Zinngrebe**
**Patentanwälte**
**Alexandrastrasse 5**
**65187 Wiesbaden (DE)**

(56) Entgegenhaltungen:
DE-A1-102011 081 234

• **LEWIN ERIK ET AL: "Comparison of Al-Si-N nanocomposite coatings deposited by HIPIMS and DC magnetron sp", SURFACE AND COATINGS TECHNOLOGY, Bd. 232, 24. Juni 2013 (2013-06-24), Seiten 680-689, XP028707141, ISSN: 0257-8972, DOI: 10.1016/J.SURFCOAT.2013.06.076**
• **PELISSON ET AL: "Microstructure and mechanical properties of Al-Si-N transparent hard coatings deposited by magnetron sputtering", SURFACE AND COATINGS TECHNOLOGY, ELSEVIER, AMSTERDAM, NL, Bd. 202, Nr. 4-7, 6. Juni 2007 (2007-06-06), Seiten 884-889, XP022342031, ISSN: 0257-8972, DOI: 10.1016/J.SURFCOAT.2007.05.094**

EP 2 942 333 B1

**Beschreibung**

Die Erfindung betrifft im Allgemeinen kratzresistente Beschichtungen, Substrate mit kratzfesten Beschichtungen sowie Verfahren zu deren Herstellung. Im Speziellen betrifft die Erfindung kratzresistente Beschichtungen und entsprechend beschichtete Substrate mit einer Hartstoffschicht basierend auf Aluminiumnitrid sowie deren Herstellung, insbesondere durch Sputtern.

Gebiet der Erfindung

Aus dem Stand der Technik sind verschiedene Beschichtungen zur Erhöhung der Kratzfestigkeit bekannt. So beschreibt die Patentanmeldung DE 102 011 081 234 A1 eine Hartstoffbeschichtung auf Glaskeramiksubstraten, welche zwei unterschiedliche Materialphasen aufweist. Nachteilig ist jedoch, dass der thermische Ausdehnungskoeffizient der Beschichtung und des Substrates um maximal 20% voneinander abweichen dürfen. Da zudem Glaskeramiken einen sehr niedrigen thermischen Ausdehnungskoeffizienten aufweisen, grenzt dies die Anzahl der geeigneten Beschichtungen stark ein. So weisen beispielsweise Hartstoffschichten basierend auf Nitriden oder Oxiden wie Aluminiumnitrid oder Bornitrid zu große thermische Ausdehnungskoeffizienten auf, so dass diese nicht zur Beschichtung von Glaskeramiksubstraten eingesetzt werden könnten.

E. Lewin et al., Surface and Coatings Technology , 2013, Bd. 232, Seiten 680-689 und A. Pelisson et al., Surface and coatings Technology, 2007, Bd. 202, Seiten 884-889 beschreiben Substrate, die mit einer Aluminumnitrid beschichtet sind. Eine Beschichtung zur Erhöhung der Kratzfestigkeit sollte nicht nur eine hohe Härte aufweisen, vielmehr sind auch Elastizität (E-Modul), Oberflächenrauhigkeit, Schichtspannungen durch unterschiedliche thermische Ausdehnungskoeffizienten von Substrat und Beschichtung sowie die Oberflächenbeschaffenheit des Substrates entscheidende Faktoren für die Güte eine kratzfesten Beschichtung bzw. des entsprechend beschichteten Substrates.

Darüber hinaus ist es wünschenswert, dass entsprechend beschichtete Oberflächen wie beispielsweise Glas- oder Glaskeramikoberflächen neben einer hohen Kratzfestigkeit auch eine hohe Resistenz gegenüber Verschleiß- und Politurbelastungen, wie sie sowohl während der Produktion als auch der späteren Verwendung auftreten, aufweisen.

Aufgabe der Erfindung

Es ist Aufgabe der Erfindung, eine Beschichtung sowie ein entsprechend beschichtetes Substrat bereit zu stellen, welches neben einer hohen Kratzfestigkeit auch eine erhöhte Beständigkeit gegenüber Verschleiß- und Polierbelastungen sowie gegenüber Umweltbelastungen aufweist. Eine weitere Aufgabe der Erfindung besteht in der Bereitstellung eines entsprechenden Herstellungsverfahrens.

Die Aufgabe der Erfindung wird in überraschender Art und Weise bereits durch den Gegenstand der unabhängigen Ansprüche gelöst. Vorteilhafte Ausgestaltungen und Weiterbildungen der Erfindung sind Gegenstand der Unteransprüche.

Kurzbeschreibung der Erfindung

Die erfindungsgemäße Beschichtung umfasst eine transparente, hochbrechende Hartstoffschicht auf Basis von Aluminiumnitrid (AlN), d.h. die Hartstoffschicht enthält AlN als einen wesentlichen Bestandteil. Erfindungsgemäß ist der Anteil an AlN in der Hartstoffschicht größer als 50 Gew.-%.

Die Hartstoffschicht wirkt auch als Verschleißschutzschicht. Die Erfinder haben dabei überraschender Weise festgestellt, dass eine besonders kratzfeste und gegen Verschleiß- und Polierbelastungen resistente Beschichtung erhalten werden kann, wenn das AlN der Hartstoffschicht kristallin oder zumindest weitgehend kristallin ist und eine hexagonale Kristallstruktur aufweist. Insbesondere weist die AlN-Schicht einen Kristallisationsgrad von zumindest 50% auf.

Dies ist insofern überraschend, da üblicherweise davon ausgegangen wird, dass amorphe Beschichtungen durch das Fehlen von Kristalliten eine geringere Oberflächenrauhigkeit aufweisen als entsprechende kristalline Beschichtungen. Eine geringe Schichtrauheit wird dabei mit einer geringeren Anfälligkeit für das Auftreten von Defekten, beispielsweise verursacht durch die Reibung eines Fremdkörpers auf der Oberfläche der Beschichtung, in Verbindung gebracht. Dennoch weist die erfindungsgemäße Beschichtung nicht nur eine hohe Kratzresistenz, sondern auch eine erhöhte Resistenz gegenüber Umwelteinflüssen sowie Polier- und Verschleißbelastungen auf. So weist die Hartstoffschicht eine hohe chemische Resistenz, beispielsweise gegenüber Reinigungsmitteln und Spülmitteln, auf. Zudem ist die erfindungsgemäße Beschichtung trotz ihrer kristallinen Struktur für Licht mit Wellenlängen im sichtbaren und infraroten Spektralbereich transparent, so dass die Beschichtung optisch unauffällig ist und beispielsweise in optischen Bauteilen wie auch als Beschichtung von Kochfeldern eingesetzt werden kann. So weist die Beschichtung insbesondere eine Transparenz für sichtbares Licht von zumindest 50%, bevorzugt von zumindest 80% bezogen auf die Normlichtart C und für infrarotes Licht eine Transparenz von zumindest 50%, bevorzugt von zumindest 80% auf.

Bei der Hartstoffschicht handelt es sich um eine hochbrechende Schicht. So weist die Hartstoffschicht in einer Ausführungsform einen Brechwert im Bereich von 1,8 bis 2,3, bevorzugt im Bereich von 1,95 bis 2,1 bei einer Wellenlänge von 550 nm auf.

Die hohe Transparenz der Beschichtung kann insbesondere durch die geringe Größe der einzelnen Kristallite erzielt werden. So werden durch die geringe Größe beispielsweise Streueffekte vermieden. In einer Ausführungsform der Erfindung beträgt die mittlere Kristallgröße höchstens 20 nm, bevorzugt höchstens 15 nm und besonders bevorzugt 5 bis 15 nm. Ein weiterer Vorteil der geringen Kristallgröße besteht in der höheren mechanischen Beständigkeit der die Kristallite enthaltenden Schicht. So weisen größere Kristallite häufig einen Versatz in ihrer Kristallstruktur auf, was sich nachteilig auf die mechanische Beständigkeit auswirkt.

Die AlN-Kristallite in der Hartstoffschicht weisen eine hexagonale Kristallstruktur mit einer vorwiegenden Vorzugsrichtung in (001)-Richtung, d.h. parallel zur Substratoberfläche auf. Bei einer Kristallstruktur mit Vorzugsrichtung wird eine der Symmetrierichtungen der Kristallstruktur von den Kristalliten bevorzugt eingenommen. Im Sinne der Erfindung wird unter einer AlN-Kristallstruktur mit einer Vorzugsrichtung in (001)-Richtung insbesondere eine Kristallstruktur verstanden, die bei einer röntgendiffraktometrischen Messung im entsprechenden XRD-Spektrum im Bereich zwischen 34° und 37° eine maximale Reflexion zeigt. Die Reflexion in diesem Bereich kann dabei einer AlN-Kristallstruktur mit einer (001)-Vorzugsrichtung zugeordnet werden.

Es konnte überraschenderweise festgestellt werden, dass erfindungsgemäße Hartstoffschichten mit einer Vorzugsrichtung in (001)-Richtung sowohl ein höheres E-Modul als auch eine größere Härte aufweisen als Hartstoffschichten mit einer gleichen oder vergleichbaren Zusammensetzung ohne (001)-Vorzugsrichtung.

Das hohe E-Modul der Beschichtung mit einer überwiegenden(001)-Vorzugsrichtung kann damit erklärt werden, dass das Elastizitätsmodul eines kristallinen Stoffes von dessen Vorzugsrichtung abhängt. Somit ist das E-Modul in der erfindungsgemäßen Hartstoffschicht parallel zur Substratoberfläche am größten. In einer Ausführungsform der Erfindung weisen die Hartstoffschichten ein E-Modul bei einer Prüfkraft von 10 mN parallel zur Substratoberfläche im Bereich von 90 bis 250 GPa, bevorzugt im Bereich von 110 bis 200 GPa auf.

Die Kratzfestigkeit einer Beschichtung hängt neben der Härte auch davon ab, wie gut die Beschichtung auf dem Substrat haftet. Zeigen Beschichtung und Substrat zudem unterschiedliche thermische Ausdehnungskoeffizienten, so kann dies zum Aufbau von Spannungen in der Beschichtung und zu einem Abplatzen der Beschichtung führen. Bei Beschichtungen mit einem vergleichsweise hohen E-Modul können dabei die auftretenden Spannungen besser abgefangen werden, so dass die Beschichtung besser auf dem Substrat haftet.

Die Resistenz der Beschichtung gegenüber Abrieb ist weiterhin auch vom Verhältnis aus Härte und E-Modul der jeweiligen Schicht abhängig. Bevorzugt weisen die Schichten daher ein Verhältnis von Härte zu E-Modul von zumindest 0,08, bevorzugt 0,1, besonders bevorzugt größer als 0,1 auf. Dies kann durch die (001)-Vorzugsrichtung erreicht werden. Hinsichtlich ihrer Zusammensetzung vergleichbare Schichten mit abweichender Vorzugsrichtung zeigen hierbei vergleichsweise geringe Werte im Bereich von 0,06 bis 0,08.

Die oben beschriebenen Eigenschaften können insbesondere erreicht werden, wenn die (001)-Vorzugsrichtung der Kristallstruktur, verglichen mit den (100)- und (101)-Richtungen, am stärksten ausgeprägt ist. Darüber hinaus ist in einer Weiterbildung der Erfindung zudem der Anteil an (100)-orientierten Kristallstrukturen größer als der Anteil an (101) orientierten Kristallstrukturen.

Zur Bestimmung des Anteils der Kristallstruktur, die eine (001)-Vorzugsrichtung aufweist, kann wie folgt vorgegangen werden:

- Aufnahme eines XRD-Spektrums der entsprechenden Schicht unter streifenden Einfall, d.h. Dünnschichtröntgenbeugung (GIXRD)
- Bestimmung der maximalen Intensität des entsprechenden (001)-Reflexes $I_{(001)}$ im Bereich zwischen 34° und 37°
- Bestimmung der maximalen Intensität des (100)-Reflexes $I_{(100)}$ im Bereich zwischen 32° und 34°
- Bestimmung der maximalen Intensität des (101)-Reflexes $I_{(101)}$ im Bereich zwischen 37° und 39°

Der Anteil der Kristallstruktur mit (001)-Vorzugsrichtung $x_{(100)}$ und $y_{(001)}$ errechnet sich wie folgt:

$$x_{(001)} = I_{(001)} / (I_{(001)} + I_{(100)})$$

und

$$y_{(001)} = I_{(001)} / (I_{(001)} + I_{(101)})$$

Als besonders vorteilhaft hat sich ein Anteil $x_{(001)}$ und/oder $y_{(100)}$ größer 0,5, bevorzugt größer 0,6 und besonders bevorzugt größer 0,75 herausgestellt.

Ein weiterer Vorteil der AlN-Schicht besteht in ihrer vergleichsweise hohen Wärmeleitfähigkeit. Dies ist insbesondere vorteilhaft, wenn die erfindungsgemäße Beschichtung als Kratzschutz auf Kochflächen aufgebracht wird.

In einer Ausführungsform der Erfindung beträgt der Anteil an Sauerstoff in der AlN-Schicht maximal 10 at%, bevorzugt maximal 5 at% und besonders bevorzugt maximal 2 at%.

Durch den niedrigen Sauerstoffgehalt in der Beschichtung wird die Bildung von Oxynitriden verhindert, welche sich nachteilig auf das Kristallwachstum, insbesondere auf die Ausbildung einer Vorzugsrichtung der Kristallstruktur, auswirken.

Die oben beschriebenen Eigenschaften der Hartstoffschicht können insbesondere dann erzielt werden, wenn die Beschichtung durch ein Sputterverfahren aufgebracht wurde.

Die Härte und die Performance der Kratzschutzwirkung einer erfindungsgemäßen Schicht kann auch durch eine Behandlung im Anschluss an deren Herstellung verbessert werden. Neben einer einfachen thermischen Behandlung in einem Ofen können weiterhin Blitzlampen-Heizen oder eine Behandlung mittels Laser angewendet werden. Auch eine Implantation durch Ionen oder Elektronen ist denkbar. Hierdurch kann eine (001)-Vorzugsrichtung der Kristallstruktur erhalten oder deren Anteil $x_{(100)}$ und/oder $y_{(001)}$ in der Kristallstruktur weiter erhöht werden.

Für den Einsatz der Beschichtungen im Bereich Kochfeld ist es wichtig, dass sich die Töpfe leicht über das Kochfeld schieben lassen. Solche Töpfe bestehen insbesondere aus Edelstahl. Bevorzugt weist daher die Beschichtung eine Haftreibung μ gegenüber Metallkörpern < 0,5, besonders bevorzugt < 0,25 auf.

Bei der AlN-Schicht bzw. Hartstoffschicht kann es sich um eine reine Aluminiumnitridschicht handeln oder die Hartstoffschicht kann neben Aluminiumnitrid weitere Bestandteile, beispielsweise ein oder mehrere weitere Nitride, Carbide und/oder Carbonitride enthalten. Bevorzugt handelt es sich bei den Nitriden, Carbiden oder Carbonitriden um die entsprechenden Verbindungen der Elemente Silizium, Bor, Zirkon, Titan, Nickel, Chrom oder Kohlenstoff. Hierdurch können Eigenschaften der Hartstoffschicht wie beispielsweise Härte, E-Modul oder die Widerstandsfähigkeit gegen Abrieb, beispielsweise die Polierresistenz, weiter modifiziert werden.

Um zu gewährleisten, dass sich auch bei diesen Ausführungsformen eine kristalline Aluminiumnitridphase ausbildet, ist ein Aluminiumgehalt der Hartstoffschicht > 50 Gew.-%, bevorzugt > 60 Gew.-% und besonders bevorzugt > 70 Gew.-%, jeweils bezogen auf die zusätzlichen Elemente Silizium, Bor, Zirkon, Titan, Nickel, Chrom und/oder Kohlenstoff, besonders vorteilhaft.

Entsprechende Mischschichten werden im Sinne der Erfindung auch als dotierte AlN-Schichten bezeichnet. Die zusätzlich zum AlN enthaltenen Verbindungen werden im Sinne der Erfindung als Dopant bezeichnet, wobei der Gehalt an Dopant bis zu 50 Gew.-% betragen kann. Hierbei werden unter dotierten Schichten im Sinne der Erfindung auch Schichten, die einen Gehalt von bis zu 50 Gew.-% an Dopant enthalten, verstanden.

Bei Mischschichten bzw. dotierten AlN-Schichten sind AlN-Kristallite in einer Matrix des Dopants eingebettet. Der Kristallisationsgrad der Schicht kann somit über den Anteil des Dopants in der Mischschicht eingestellt werden. Zudem wird die Kristallitgröße durch die Matrix begrenzt. Als besonders vorteilhaft hat sich dabei eine Kristallitgröße von maximal 20 nm, bevorzugt von maximal 15 nm herausgestellt. Insbesondere liegt die mittlere Größe der AlN-Kristallite im Bereich von 5 bis 15 nm. Diese Kristallitgröße gewährleistet eine hohe Transparenz und mechanische Beständigkeit der Hartstoffschicht.

In einer Ausführungsform der Erfindung enthält die Hartstoffschicht neben Aluminiumnitrid Bornitrid, d.h. die Schicht ist mit Bornitrid dotiert. Durch das enthaltene Bornitrid wird der Reibwert der Schicht reduziert, was insbesondere zu einer höheren Resistenz der Schicht gegenüber Polierprozessen führt. Dies ist sowohl in Hinblick auf die Beständigkeit eines entsprechend beschichteten Substrates bei der Verwendung durch den Endverbraucher wie auch in Hinblick auf mögliche Verfahrensschritte bei der Weiterverarbeitung des beschichteten Substrates vorteilhaft.

In einer anderen Ausführungsform der Erfindung ist die Hartstoffschicht mit Siliziumnitrid dotiert, d.h. es handelt sich um ein AlN:SiN-Materialsystem, durch welches einzelne Eigenschaften wie z.B. die Haftung, die Härte, die Rauigkeit, der Reibwert und/oder die thermische Beständigkeit beeinflusst werden können. In einer Weiterbildung dieser Ausführungsform weist die Hartstoffschicht zumindest einen weiteren Dopanten auf.

Des Weiteren kann der thermische Ausdehnungskoeffizient der Hartstoffschicht durch Art und Menge des eingesetzten Dopants beeinflusst werden oder auf das Substrat adaptiert werden.

Eine Weiterbildung der Erfindung sieht vor, dass die Beschichtung zusätzlich zur Hartstoffschicht zumindest eine weitere Schicht aufweist. Gemäß einer Ausführungsform weist die Beschichtung neben der Hartstoffschicht eine Deckschicht auf, welche oberhalb der Hartstoffschicht angeordnet ist. Die Bezeichnung oberhalb bezieht sich auf den Aufbau der Beschichtung ausgehend vom Substrat, d.h. die Hartstoffschicht ist somit zwischen dem Substrat und der Deckschicht angeordnet. Durch das Aufbringen einer Deckschicht auf die Hartstoffschicht können einzelne Eigenschaften wie z.B. das optische Erscheinungsbild oder die Poliereigenschaften gegenüber einem bestimmten Poliermedium modifiziert werden.

Eine Ausführungsform der Erfindung sieht vor, dass die Deckschicht durch Nitride, Oxide, Carbide, Carbonitride und/oder Oxinitride ausgewählt aus der Gruppe der Elemente Aluminium, Silizium, Bor, Zirkon, Titan, Nickel oder Kohlenstoff gebildet wird. Die Deckschicht kann als eine Mischschicht mehrerer der oben genannten Verbindungen oder als eine Schicht einer Verbindung ausgebildet sein. Bevorzugt wird die Deckschicht durch Sputtern aufgebracht. Alternativ können auch CVD oder Sol Gel Technologien eingesetzt werden.

Bei der Deckschicht kann es sich beispielsweise um eine $SiO_2$-haltige Schicht handeln. Abhängig von der Schichtdicke der Deckschicht kann somit beispielsweise der Farbort der Reflexionsfarbe und/oder die Reflexionseigenschaften der Beschichtung verändert werden.

In einer weiteren Ausführungsform weist die Hartstoffschicht eine kohlenstoffhaltige Deckschicht auf. Der Kohlenstoffgehalt der Deckschicht führt dabei zu einer Verringerung des Reibwertes, was insbesondere bei beschichteten Substraten, die als Kochfläche verwendet werden, vorteilhaft ist, da sich so die Topfe leichter auf dem Kochfeld verschieben lassen. Des Weiteren können die Poliereigenschaften und die Resistenz der Beschichtung gegenüber Poliermedien verbessert werden. Die Deckschicht kann beispielsweise Carbide und/oder Graphit enthalten.

Alternativ oder zusätzlich kann die Beschichtung eine Haftvermittlerschicht aufweisen. Diese ist zwischen dem Substrat und der Hartstoffschicht angeordnet und verbessert die Anhaftung der Hartstoffschicht auf dem Substrat. Dies ist insbesondere dann vorteilhaft, wenn die thermischen Ausdehnungskoeffizienten von Substrat und Hartstoffschicht sich deutlich unterscheiden. Als besonders vorteilhaft haben sich hierbei solche Haftvermittlerschichten herausgestellt, die aus Nitriden, Oxiden, Carbiden, Carbonitriden und/oder Oxynitriden der Elemente Aluminium, Silizium, Bor, Zirkon, Titan, Nickel, Chrom und/oder Kohlenstoff gebildet werden.

Die Haftvermittlerschicht kann hierbei auftretende Spannungen reduzieren, zumindest führt sie zu einer starken chemischen Anbindung an das Substrat. Eine entsprechende enge Anpassung der thermischen Ausdehnungskoeffizienten von Substrat und Hartstoffschicht ist daher nicht notwendig. Dies ermöglicht eine breite Auswahl an geeigneten Substratmaterialien. Die Abscheidung kann beispielsweise über PVD, CVD oder Sol-Gel-Verfahren erfolgen.

Als Substrate werden Glaskeramiken verwendet.

In einer bevorzugten Ausführungsform handelt es sich bei dem Substrat insbesondere um eine Glaskeramik mit einem thermischen Ausdehnungskoeffizienten $\alpha_{20-300}$ kleiner als $2*10^{-6}$ $K^{-1}$. Entsprechende Glaskeramiken können beispielsweise als Kochflächen verwendet werden. Da die erfindungsgemäßen Beschichtungen zudem gegenüber Temperaturen von zumindest 300°C, bevorzugt von zumindest 400°C dauerhaft stabil sind, kann die Beschichtung auch auf den Heißzonen des Kochfeldes aufgebracht werden.

Auf Grund der hohen Temperaturstabilität kann die Beschichtung bzw. entsprechend beschichtete Glassubstrate in anderen Heißbereichen, beispielsweise als Ofensichtscheibe, verwendet werden.

Insbesondere bei Kochfeldern wird häufig ein Dekor auf die Glaskeramikoberfläche aufgedruckt. Eine Ausführungsform sieht daher vor, dass das Substrat zumindest teilweise mit einer Dekorschicht versehen wird und die Dekorschicht zwischen dem Substrat und der Beschichtung angeordnet ist. Auf Grund der hohen Transparenz der erfindungsgemäßen Beschichtung ist das Dekor durch die Beschichtung gut wahrnehmbar. Zudem wird die Dekorschicht durch die Hartstoffschicht vor mechanischen Belastungen geschützt, so dass an die Dekorschicht geringere Anforderungen in Hinblick auf deren mechanische Belastbarkeit gestellt werden können.

Das mit der erfindungsgemäßen Hartstoffschicht beschichtete Substrat kann insbesondere als optisches Bauteil, Kochfläche, Sichtscheiben im Fahrzeugbereich, Uhrengläsern, Glas- oder Glaskeramikbauteile in Haushaltsgeräten, Ofensichtscheiben oder als Display beispielsweise für Tablet-PCs oder Mobiltelefone, insbesondere als Touchdisplay verwendet werden.

Die Hartstoffschichten bzw. das erfindungsgemäß beschichtete Substrat kann dabei insbesondere mit einem Verfahren hergestellt werden, dass zumindest die folgenden Schritte umfasst:

a) Bereitstellen eines Substrates in einer Sputtervorrichtung mit einem aluminiumhaltigen Target

b) Abgabe von gesputterten Partikeln mit einer Leistung im Bereich von 8 bis 1000 W/cm$^2$, bevorzugt 10 - 100 W/cm$^2$ pro Targetfläche.

Die Beschichtung des Substrates in Schritt b) erfolgt dabei ab niedrigen Enddrücken. So liegt der Enddruck in der Beschichtungsanlage, d.h. der Druck, ab dem ein Beschichtungsvorgang gestartet werden kann, bei höchstens $2*10^{-5}$ mbar, bevorzugt sogar bei Drücken im Bereich von $1*10^{-6}$ bis $5*10^{-6}$ mbar. Durch die geringen Enddrücke wird die Fremdgasmenge minimiert, d.h. der Beschichtungsprozess wird in einer sehr reinen Atmosphäre durchgeführt. Dies gewährleistet eine hohe Reinheit der aufgebrachten Schichten. So wird durch prozessbedingten geringen Restgasgehalt die Bildung von Oxynitriden durch den Einbau von Sauerstoff vermieden. Dies ist insbesondere in Hinblick auf das Kristallwachstum der AlN-Kristallite von Bedeutung, da dieses durch Oxynitride gestört wird. Bevorzugt kann somit eine Beschichtung mit einem Sauerstoffgehalt von maximal 10 at-%, besonders bevorzugt von maximal 5 at-% oder sogar maximal 2 at-% erhalten werden. Dagegen wird bei konventionellen Sputterverfahren mit einem Enddruck im Bereich von zumindest $5*10^{-5}$ mbar beschichtet, entsprechend ist hier der Sauerstoffanteil in der abgeschiedenen Beschichtung höher.

Beim Sputterprozess wird nach Erreichen des erfindungsgemäßen Enddrucks ein stickstoffhaltiges Prozessgas eingeleitet. Der Anteil des Stickstoffs am Gesamtfluss beträgt zumindest 30 Vol.-%, bevorzugt zumindest 40 Vol.-% und besonders bevorzugt zumindest 50 Vol.-% . Über den Anteil des Stickstoffs am Gesamtfluss während des Sputterprozesses kann die chemische Resistenz der abgeschiedenen Schicht, beispielsweise gegenüber Spülmitteln oder Reinigungsmitteln beeinflusst werden. So steigt die Resistenz der Schicht gegenüber Chemikalien mit steigendem Stickstoffanteil.

Die Beschichtung in Schritt b) erfolgt mit hohen Sputterleistungen. Die Sputterleistungen im erfindungsgemäßen Verfahren betragen hierbei zumindest 8 - 1000 W/cm$^2$, bevorzugt zumindest 10 - 100 W/cm$^2$. In einer Ausführungsform der Erfindung wird ein Magnetronsputtern oder ein High Power Impulse Magnetron Sputtering-Verfahren (HiPIMS) angewendet. Alternativ oder zusätzlich kann zwischen dem Target und dem Substrat eine negative Spannung oder eine Wechselspannung aufrechterhalten werden. Die Beschichtung kann alternativ oder zusätzlich mit Unterstützung von Ionenbeschuss, bevorzugt mit Ionenbeschuss aus einer Ionenstrahlquelle und/oder durch Anlegen einer Spannung am Substrat erfolgen.

Gemäß einer Ausführungsform der Erfindung werden die durch das Sputtern erzeugten Partikel bei einer Depositionstemperatur größer als 100°C, bevorzugt größer 200°C und besonders bevorzugt größer 300°C abgeschieden. In Kombination mit den niedrigen Prozessdrücken sowie der hohen Sputterleistungen kann somit das Wachstum der AlN-Kristallite, insbesondere die Kristallitgröße und die Vorzugsrichtung der Kristallstruktur, in besonders vorteilhafter Weise beeinflusst werden. Es ist jedoch auch eine Abscheidung bei niedrigeren Temperaturen, beispielsweise bei Raumtemperatur, möglich. Die gemäß dieser Ausführungsform hergestellten Hartstoffschichten zeigen ebenfalls gute mechanische Eigenschaften wie eine hohe Kratzresistenz.

Bei dem Sputterprozess kann es sich um eine kontinuierliche Deposition auf dem Substrat handeln. Alternativ kann der Sputtervorgang auch derart durchgeführt werden, dass die abgeschiedenen Schichten Interfaces aufweisen bzw. aus Interfaces bestehen, welche auf Grund der Prozessierung beim Herausfahren aus dem Beschichtungsbereich entstehen.

In Schritt a) kann als Substrat beispielsweise eine Glaskeramik, ein Saphirglas, ein Borosilikatglas, ein Aluminosilikatglas, ein Kalk-Natronglas, ein synthetisches Quarzglas, ein Lithiumaluminosilikatglas, ein optisches Glas und/oder ein Kristall für optische Zwecke bereit gestellt werden.

In einer Ausführungsform der Erfindung enthält das Target neben Aluminium zumindest eines der Elemente Silizium, Bor, Zirkon, Titan oder Kohlenstoff. Diese zusätzlichen Elemente neben Aluminium werden im Sinne der Erfindung auch als Dopant bezeichnet. Bevorzugt ist der Anteil an Aluminium im Target größer als 50 Gew.-%, besonders bevorzugt größer 60 Gew.-% und ganz besonders bevorzugt größer als 70 Gew.-%.

In einer Weiterbildung der Erfindung wird in Schritt a) ein Substrat bereitgestellt, welches eine Dekor und/oder eine Haftvermittlerschicht aufweist.

So ist beispielsweise eine Beschichtung von zumindest teilweise dekorierten Bereichen möglich und bleibt auch bei hohen Anwendungstemperaturen resistent. Auch Flachfacetten sind ohne optische Veränderungen beschichtbar und zeigen eine gute mechanische Beständigkeit.

Alternativ oder zusätzlich wird in einem dem Schritt b) nachfolgenden Verfahrensschritt eine Deckschicht auf der Hartstoffschicht aufgebracht.

Gemäß einer Ausführungsform der Erfindung enthält die Haftvermittlerschicht und/oder die Deckschicht Nitride, Oxide, Carbide, Carbonitride und/oder Oxynitride eines oder mehrerer Elemente ausgewählt aus der Gruppe umfassend Aluminium, Silizium, Bor, Zirkon, Titan, Nickel und Kohlenstoff.

Bevorzugt werden Haftvermittlerschicht und/oder Deckschicht durch einen Sputterprozess aufgebracht.

Detaillierte Beschreibung der Erfindung

Nachfolgend wird die Erfindung an Hand von Figuren und Ausführungsbeispielen näher erläutert. Es zeigen dabei:

Fig. 1 eine schematische Darstellung eines erfindungsgemäß beschichteten Substrates,

Fig. 2 eine schematische Darstellung einer Ausführungsform der Erfindung mit zusätzlicher Haftvermittlerschicht,

Fig. 3 eine schematische Darstellung einer Ausführungsform der Erfindung mit zusätzlicher Deckschicht,

Fig. 4 eine schematische Darstellung einer Ausführungsform der Erfindung mit zusätzlicher Haftvermittlerschicht und zusätzlicher Deckschicht,

Fig. 5 ein EDX-Spektrum einer dotierten AlN-Hartstoffschicht,

Fig. 6a und 6b TEM-Aufnahmen zweier mit AlN-SiN-Mischschichten mit unterschiedlichem AlN-Gehalten,

Fig. 7 das XRD-Spektrum eines Ausführungsbeispiels,

Fig. 8 die XRD-Spektren zweier AlN-Hartstoffschichten mit unterschiedlichen Vorzugsrichtungen,

Fig. 9a bis 9c fotografische Aufnahmen verschiedener beschichteter Substrate mit unterschiedlichen Vorzugsrichtungen nach einem mechanischen Belastungstest mit Sand und

Fig. 10a und 10b fotografische Aufnahmen verschiedener beschichteter Substrate mit unterschiedlichen Vorzugsrichtungen der Kristallstruktur nach einem mechanischen Belastungstest mit Siliziumcarbid.

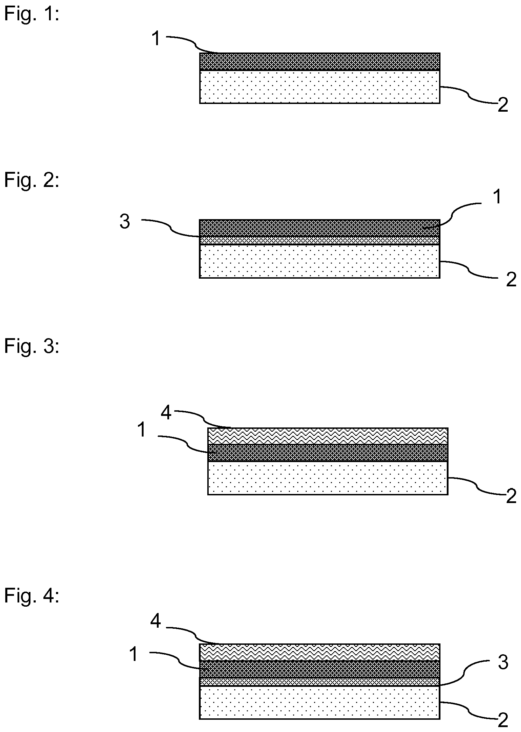

In Fig. 1 wird schematisch ein erfindungsgemäß beschichtetes Substrat dargestellt. Hierbei ist das Substrat 1 mit einer Hartstoffschicht 1 beschichtet. Die Hartstoffschicht 1 umfasst kristallines AlN, wobei die AlN-Kristallite eine (001)-Vorzugsrichtung aufweisen. Auf Grund der Schichteigenschaften der Hartstoffschicht 1, insbesondere der großen Härte sowie eines großen E-Moduls ist bereits eine Schichtdicke der Hartstoffschicht 1 von nur 200 nm, bevorzugt sogar von nur 100 nm ausreichend, um das Substrat 2 vor mechanischen Belastungen und Kratzern zu schützen. Dickere Schichten bis 2000nm sind aber ebenfalls denkbar.

Fig. 2 zeigt schematisch ein weiteres Ausführungsbeispiel, bei dem zwischen dem Substrat 2 und der Hartstoffschicht 1 eine weitere Schicht 3 angeordnet ist. Bei der zusätzlichen Schicht 3 kann es sich beispielsweise um eine Dekorschicht oder eine Haftvermittlerschicht handeln. Auch solche Schichten 3, die aus mehreren Teilschichten, beispielsweise einer Dekor- und einer Haftvermittlerschicht, bestehen, sind möglich. Das Substrat kann dabei vollständig oder auch nur teilweise mit der Schicht 3 versehen werden. Die Hartstoffschicht ist dabei über der zusätzlichen Schicht 3 angeordnet, d.h. die zusätzliche Schicht 3 ist somit zwischen Substrat 2 und Hartstoffschicht 1 angeordnet. Bei Ausführungsformen mit einer Haftvermittlerschicht als zusätzliche Schicht 3 handelt es sich bei der Schicht 3 bevorzugt um eine dotierte AlN-Schicht bzw. eine Mischschicht. Abhängig von der Zusammensetzung der Haftvermittlerschicht kann diese beispielsweise einen thermischen Ausdehnungskoeffizienten aufweisen, welcher zwischen den thermischen Ausdehnungskoeffizienten von Substrat 2 und Hartstoffschicht 1 liegt. Somit können Spannungen zwischen Substrat 2 und Hartstoffschicht 1 durch die Haftvermittlerschicht 3 verringert werden. Bevorzugt weist die Haftvermittlerschicht 3 eine Dicke im Bereich von 1 bis 900 nm, besonders bevorzugt im Bereich von 1 bis 500nm, besonders bevorzugt im Bereich von 1 bis 50nm auf. Gemäß einem Ausführungsbeispiel weist das beschichtete Substrat zwischen Glassubstrat 2 und der Hartstoffschicht 1 als Haftvermittlerschicht 3 eine $Al_2O_3$-Beschichtung mit einer Schichtdicke von 50nm auf.

In Fig. 3 ist eine weitere Ausführungsform der Erfindung schematisch dargestellt. Hierbei wird eine Deckschicht 4 auf die Hartstoffschicht 1 aufgebracht. Die Deckschicht 4 enthält in diesem Ausführungsbeispiel $SiO_2$ und weist eine Schichtdicke von 1 bis 100 nm auf.

Fig. 4 zeigt ein weiteres Ausführungsbeispiel, bei dem das beschichtete Substrat neben der Hartstoffschicht 1 sowohl eine zusätzliche Schicht 3 als auch eine Deckschicht 4 aufweist.

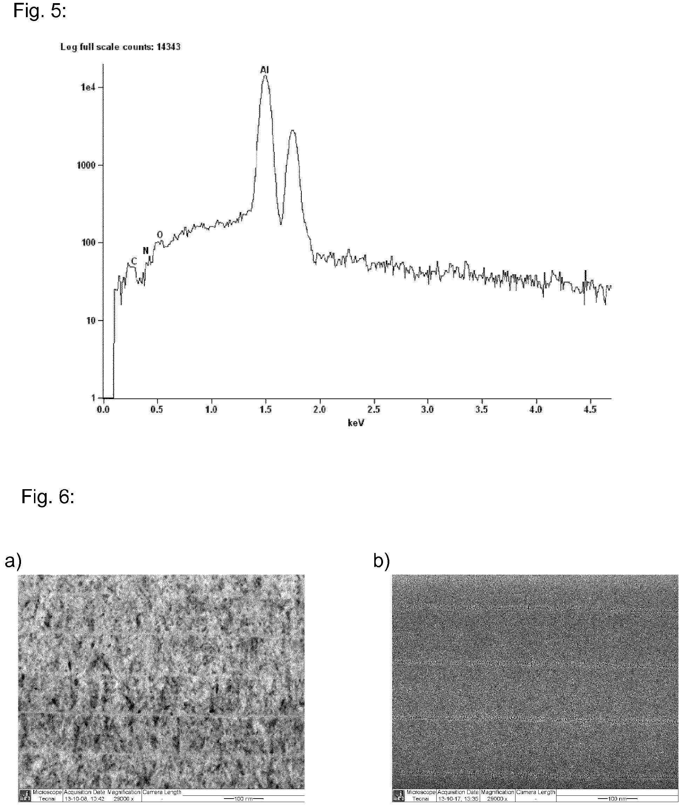

Fig. 5 zeigt das Spektrum einer EDX-Analyse (energy dispersive X-ray spectroscopy bzw. energiedispersive Röntgenanalyse) eines Ausführungsbeispiels einer erfindungsgemäßen Hartstoffschicht. Es handelt sich in diesem Ausführungsbeispiel bei der Hartstoffschicht um eine mit Silizium legierte bzw. dotierte AlN-Schicht.

In Fig. 6a ist eine transmissionselektronenmikroskopische (TEM) Aufnahme einer erfindungsgemäßen Hartstoffschicht abgebildet. Bei dem in Fig. 6a gezeigten TEM-Bild handelt es sich um eine Aufnahme einer AlN-Schicht, die mit SiN dotiert wurde, d.h. eine AlN:SiN Schicht wobei der Gehalt an AlN 75 Gew.-% und der Gehalt an SiN 25 Gew.-% beträgt. An Hand der Fig. 6a ist dabei ersichtlich, dass das AlN der Hartstoffschicht kristallin in einer SiN-Matrix vorliegt. Im Gegensatz dazu ist eine AlN:SiN Schicht, bei der AlN und SiN zu gleichen Teilen vorliegen, amorph. Eine TEM-Aufnahme einer entsprechenden Schicht wird in Fig. 6b gezeigt. Der hohe Gehalt an SiN verhindert hierbei die Bildung von AlN-Kristalliten.

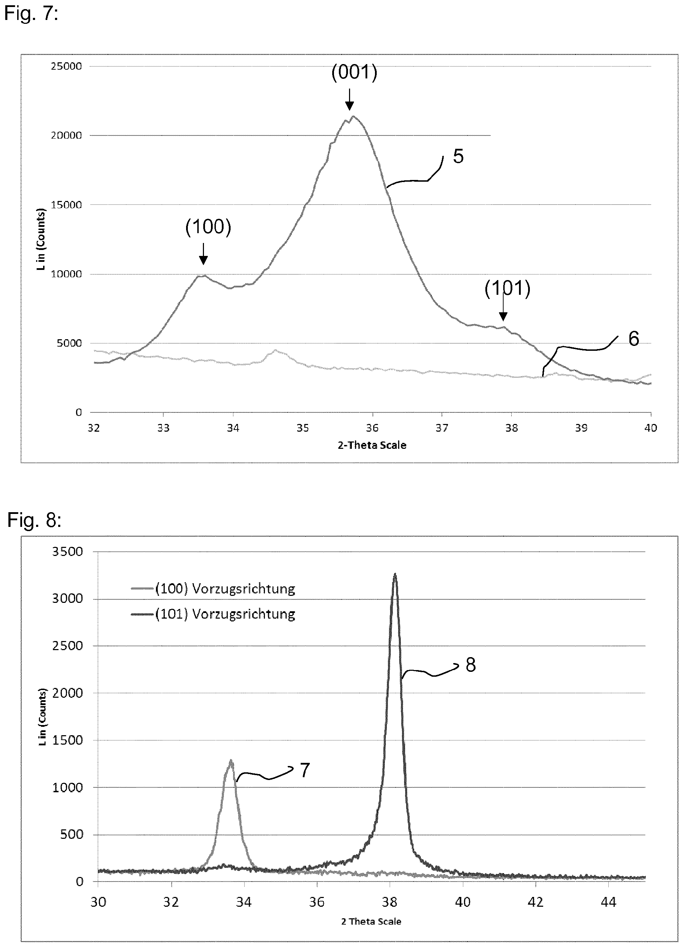

Fig. 7 zeigt das XRD-Spektrum (X-ray diffraction, Röntgenbeugung) eines Ausführungsbeispiels eines erfindungsgemäß beschichteten Substrates. Bei diesem Ausführungsbeispiel wurde ein $SiO_2$-Substrat mit einer AlN/SiN-Hartstoffschicht beschichtet und ein XRD-Spektrum des beschichteten Substrates aufgenommen. Das Spektrum 5 zeigt dabei drei Reflexe, die den drei Orientierungen (100), (001) und (101) der hexagonalen Kristallstruktur des AlN zugeordnet werden können. Hierbei wird deutlich, dass die Hartstoffschicht vorwiegend eine (001)-Vorzugsrichtung aufweist. Der entsprechende Reflex bei 36° ist dabei wesentlich stärker ausgeprägt als die Reflexe der (100)-Orientierung (33,5°) und der (101)-Orientierung (38°).

Der Anteil der Kristallstruktur mit (001)-Vorzugsrichtung kann dabei aus dem Spektrum 7 wie folgt bestimmt werden:

| $I_{(001)}$ [counts] | $I_{(100)}$ [counts] | $I_{(010)}$ [counts] |
|---|---|---|
| 21000 | 10000 | 6000 |

$$x_{(001)} = I_{(001)} / (I_{(001)} + I_{(100)})$$

und

$$y_{(001)} = I_{(001)} / (I_{(001)} + I_{(101)})$$

Der Anteil $x_{(001)}$ beträgt bei diesem Ausführungsbeispiel 0,67 und der Anteil $y_{(001)}$ 0,77.

Bei der Messkurve 6 handelt es sich um das XRD-Spektrum des unbeschichteten Substrates.

Die Hartstoffschicht wurde dabei mit einer Sputterleistung im Bereich >15 W/cm² bei einem geringen Target - Substratabstand im Bereich von 10 bis 12 cm abgeschieden. Die Prozesstemperatur betrug 250°C.

Fig. 8 zeigt XRD-Spektrum von Hartstoffschichten, die zwar eine vergleichbare Zusammensetzung wie das in Fig. 7 gezeigte Ausführungsbeispiel, jedoch andere Vorzugsrichtungen der Kristallstruktur aufweisen. So ist das Spektrum 7 einem Vergleichsbeispiel mit einer (100)-Vorzugsrichtung und das Spektrum 8 einem Vergleichsbeispiel mit einer (101)-Vorzugsrichtung zuzuordnen.

Die Hartstoffschicht mit der (100)-Vorzugsrichtung (Kurve 8) wurde dabei wie mit einem hohen Target-Substratabstand (> 15 cm) und einer geringen Sputterleistung von 13 W/cm² abgeschieden. Die Prozesstemperatur lag bei ca. 100°C. Die Hartstoffschicht mit der (101)-Vorzugsrichtung (Kurve 7) wurde mit einer noch geringeren Sputterleistung von 9,5 W/cm² abgeschieden. Target-Substrat-Abstand sowie Prozesstemperatur entsprechen dabei den Abscheidebedingungen der Hartstoffschicht mit (100)-Vorzugsrichtung.

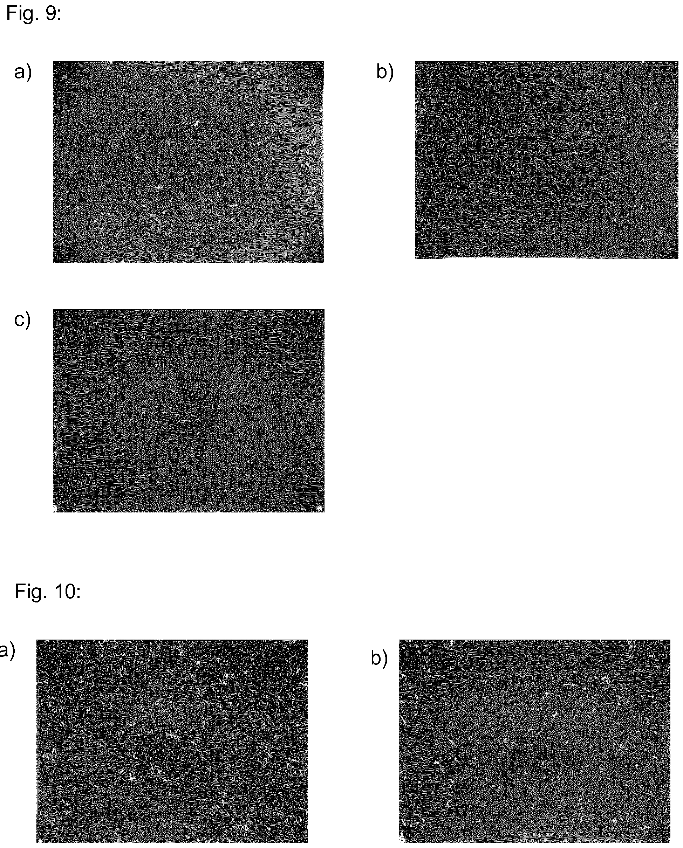

Anhand der Fig. 9a bis 10 b ist dabei der Einfluss der Vorzugsrichtung der Kristallstruktur auf die mechanische Beständigkeit der jeweiligen Hartstoffschichten zu erkennen. In den Fig. 9a bis 9c handelt es sich um fotografische Ausnahmen verschiedener beschichteter Substrate nach einem Belastungstest mit Sand. Hierbei wurde jeweils Sand auf die beschichteten Substrate gegeben und dieser unter Verwendung von Beschwerdekörpern 100-fach in einem Behältnis oszilliert. Fig. 9a zeigt dabei die Aufnahme nach dem Belastungstest einer Probe mit einer Beschichtung mit (101)-Vorzugsrichtung, Fig. 9b eine entsprechende Aufnahme einer Probe mit (100)-Vorzugsrichtung und Fig. 9c die Aufnahme einer Probe mit einer erfindungsgemäßen (001)-Vorzugsrichtung. Wie aus den Fig. 9a bis 9c deutlich wird, weisen die Proben mit (101)-und (100)-Vorzugsrichtung nach dem Belastungstest eine wesentlich höhere Anzahl an Kratzern auf als die Probe mit einer (001)-Vorzugsrichtung. Bei der in Fig. 9c gezeigten Probe handelt es sich dabei um das Ausführungsbeispiel, dessen XRD-Spektrum in Fig. 7 abgebildet wird.

Die Fig. 10a und 10b zeigen beschichtete Substrate nach einem mechanischen Belastungstest mit SiC. Dieser Belastungstest simuliert insbesondere die Resistenz gegenüber sehr harten Materialien und die Reinigbarkeit gegenüber jeglichen Reinigern und Hilfsmitteln. Der Testablauf ist vergleichbar zum Sandtest. Die Beschichtung der in Fig. 10a gezeigten Probe weist dabei keine Ausrichtung der Kristallite in (001)-Richtung auf, während die Beschichtung der in Fig. 10b gezeigten Probe eine vorwiegende (001)-Ausrichtung aufweist. Bei dem Vergleich der Fig. 10a und 10b wird deutlich, dass die Probe mit vorwiegender (001)-Ausrichtung wesentlich weniger Kratzer aufweist als die Probe ohne vorwiegende (001)-Ausrichtung der Kristallite.

**Patentansprüche**

1. Substrat mit einer Beschichtung zur Erhöhung der Kratzfestigkeit, wobei die Beschichtung zumindest eine hochbrechende, transparente Hartstoffschicht umfasst, wobei die Hartstoffschicht kristallines Aluminiumnitrid enthält und wobei das Aluminiumnitrid eine hexagonale Kristallstruktur mit einer vorwiegenden (001)-Vorzugsrichtung der hexagonalen Symmetrie aufweist und das Substrat eine Glaskeramik ist.

2. Substrat gemäß Anspruch 1, wobei der Anteil der Kristallstruktur mit (001)-Vorzugsrichtung $x_{(001)}$

$$x_{(001)} = I_{(001)} / (I_{(001)} + I_{(100)})$$

und/oder

$$y_{(001)} = I_{(001)} / (I_{(001)} + I_{(101)})$$

bestimmt mit Hilfe einer XRD-Messung der Beschichtung größer 0,5, bevorzugt größer 0,6 und besonders bevorzugt größer 0,75 ist.

3. Substrat einem der vorstehenden Ansprüche, wobei das E-Modul der Beschichtung bei einer Prüfkraft von 10 mN 80 bis 250 GPa, bevorzugt 110 bis 200 GPa und/oder Verhältnis von Härte zu E-Modul zumindest 0,08, bevorzugt zumindest 0,1, und besonders bevorzugt > 0,1 ist.

4. Substrat gemäß einem der vorstehenden Ansprüche, wobei die mittlere Kristallgröße höchstens 25 nm, bevorzugt höchstens 15 nm und besonders bevorzugt 5 bis 15 nm beträgt.

5. Substrat gemäß einem der vorstehenden Ansprüche, wobei das Aluminiumnitrid der Hartstoffschicht mit einem oder mehreren Nitriden, Carbiden und/oder Carbonitriden ausgewählt aus der Gruppe der Elemente Silizium, Bor, Zirkon, Titan, Nickel, Chrom oder Kohlenstoff dotiert ist und wobei der Aluminiumgehalt in der Hartstoffschicht bezogen auf das Dotiermaterial bevorzugt größer als 50 Gew.-%, besonders bevorzugt größer als 60 Gew.-% und ganz besonders bevorzugt größer als 70 Gew.-% ist.

6. Substrat gemäß einem der vorherigen Ansprüche, wobei der Anteil an Sauerstoff in der Hartstoffschicht maximal 10 at%, bevorzugt weniger als 5 at% und besonders bevorzugt weniger als 2 at% beträgt.

7. Substrat gemäß einem der vorherigen Ansprüche, wobei die Beschichtung eine zusätzliche Deckschicht, bevorzugt eine Deckschicht aus Nitriden, Oxiden, Carbiden, Carbonitriden und/oder Oxinitriden ausgewählt aus der Gruppe der Elemente Aluminium, Silizium, Bor, Zirkon, Titan oder Kohlenstoff, aufweist, welche oberhalb der Hartstoffschicht angeordnet ist und/oder
zwischen dem Substrat und der Hartstoffschicht eine Haftvermittlerschicht, bevorzugt eine Haftvermittlerschicht gebildet aus Nitriden, Oxiden, Carbiden, Carbonitriden und/oder Oxinitriden ausgewählt aus der Gruppe der Elemente Aluminium, Silizium, Bor, Zirkon, Titan, Nickel, Chrom oder Kohlenstoff angeordnet ist und/oder das Substrat zumindest teilweise dekorierte Bereiche aufweist, wobei die dekorierten Bereiche zwischen dem Substrat und der Beschichtung angeordnet sind.

8. Substrat gemäß einem der vorherigen Ansprüche, wobei das Substrat eine Glaskeramik mit einem thermischen Ausdehnungskoeffizienten $\alpha_{20-300}$ kleiner als $2*10^{-6}$ K$^{-1}$ ist.

9. Substrat gemäß einem der vorherigen Ansprüche, wobei die Beschichtung gegenüber Temperaturen von zumindest 300°C, bevorzugt von zumindest 400°C dauerhaft stabil ist und/oder die Beschichtung für Licht mit Wellenlängen im sichtbaren und/oder infraroten Bereich eine Transparenz T von zumindest 50%, bevorzugt von zumindest 80% aufweist.

10. Verfahren zur Herstellung einer kratzfesten Beschichtung mit einer kristallinen aluminiumnitridhaltigen Hartstoffschicht auf einem Substrat gemäss einem der vorstehenden Ansprüche, mit folgenden Schritten

a) Bereitstellen eines Substrates in einer Sputtervorrichtung mit einem aluminiumhaltigen Target, wobei als Substrat ein Glaskeramiksubstrat bereit gestellt wird,
b) Abgabe von gesputterten Partikeln mit einer Leistungsdichte im Bereich von 8 bis 1000 W/cm$^2$, bevorzugt 10 - 100 W/cm$^2$ pro Targetfläche, ab Endrücken von maximal $2*10^{-5}$ mbar.

11. Verfahren gemäß Anspruch 10, wobei als Sputterverfahren das Magnetronsputtern oder HiPIMS (High Power Impulse Magnetron Sputtering)

- Verfahren angewendet wird,

eine negative Spannung oder eine Wechselspannung zwischen Target und Substrat aufrechterhalten wird,
die Beschichtung mit Unterstützung von Ionenbeschuss, bevorzugt mit Ionenbeschuss aus einer Ionenstrahlquelle und/oder durch Anlegen einer Spannung am Substrat erfolgt und/oder die Hartstoffschicht auf einem Substrat mit aufgerauter oder geätzter Oberfläche abgeschieden wird.

12. Verfahren gemäß einem der Ansprüche 10 oder 11, wobei als Target ein Aluminiumtarget mit einer Dotierung durch zumindest eines der Elemente Silizium, Bor, Zirkon, Titan, Nickel, Chrom oder Kohlenstoff verwendet wird, wobei das Target bevorzugt einen Aluminiumgehalt größer als 50 Gew.-%, besonders bevorzugt größer 60 Gew.-% und ganz besonders bevorzugt größer 70 Gew.-% aufweist.

13. Verfahren gemäß einem der Ansprüche 10 bis 12, wobei das in Schritt a) bereitgestellte Substrat eine Dekorschicht und/oder eine Haftvermittlerschicht, bevorzugt eine Haftvermittlerschicht aus Nitriden, Oxiden, Carbiden, Carbonitriden und/oder Oxinitriden ausgewählt aus der Gruppe der Elemente Aluminium, Silizium, Bor, Zirkon, Titan, Nickel, Chrom oder Kohlenstoff, aufweist.

14. Verfahren gemäß einem der Ansprüche 10 bis 23, wobei in einem dem Schritt b) nachfolgendem Schritt eine Deckschicht, bevorzugt eine Deckschicht aus Nitriden, Oxiden, Carbiden, Carbonitriden und/oder Oxinitriden ausgewählt aus der Gruppe der Elemente Aluminium, Silizium, Bor, Zirkon, Titan, Nickel oder Kohlenstoff, auf der Hartstoffschicht aufgebracht wird.

15. Verfahren gemäß einem der vorherigen Ansprüche 10 bis 14, wobei die Partikel in Schritt b) bei Enddrücken im Bereich kleiner $2*10^{-5}$ mbar, bevorzugt im Bereich von $1*10^{-6}$ bis $5*10^{-6}$ mbar abgeschieden werden und/oder der Stickstoffanteil am Gesamtfluss zumindest 30 Vol.-%, bevorzugt zumindest 40 Vol.-% und besonders bevorzugt zumindest 50 Vol.-% beträgt.

16. Verwendung eines beschichteten Substrates gemäß einem der Ansprüche 1 bis 9 als optisches Bauteil, Kochfläche, Displays oder Sichtscheiben im Fahrzeugbereich, Uhrengläsern, Ofensichtscheibe, Glas- oder Glaskeramikbauteile in Haushaltsgeräten oder als Display beispielsweise für Tablet-PCs oder Mobiltelefone, insbesondere als Touchdisplay.

**Claims**

1. A substrate having a coating for enhancing scratch resistance, the coating comprising at least one high refractive index transparent hard material layer, wherein the hard material layer includes crystalline aluminum nitride and wherein said aluminum nitride has a hexagonal crystal structure exhibiting a predominant (001) preferred orientation of the hexagonal symmetry; and wherein the substrate is a glass ceramic.

2. The substrate according to claim 1, wherein the proportion of the crystal structure with (001) preferred orientation,

$$x_{(001)} = I_{(001)} / (I_{(001)} + I_{(100)})$$

and/or

$$y_{(001)} = I_{(001)} / (I_{(001)} + I_{(101)})$$

as determined by an XRD measurement of the coating, is greater than 0.5, preferably greater than 0.6, and more preferably greater than 0.75.

3. The substrate according to any one of the preceding claims, wherein the coating has a modulus of elasticity at a test load of 10 mN of 80 to 250 GPa, preferably 110 to 200 GPa, and/or wherein a ratio of hardness to the modulus of elasticity is at least 0.08, preferably at least 0.1, and more preferably > 0.1.

4. The substrate according to any one of the preceding claims, wherein an average crystallite size is at most 25 nm, preferably at most 15 nm, and more preferably from 5 to 15 nm.

5. The substrate according to any one of the preceding claims, wherein the aluminum nitride of the hard material layer is doped with one or more nitrides, carbides and/or carbonitrides selected from the group of elements silicon, boron, zirconium, titanium, nickel, chromium, or carbon; and wherein the aluminum content in the hard material layer, based on the dopant material, is preferably greater than 50 wt%, more preferably greater than 60 wt%, and most preferably greater than 70 wt%.

6. The substrate according to any one of the preceding claims, wherein the proportion of oxygen in the hard material layer is at most 10 at%, preferably less than 5 at%, and most preferably less than 2 at%.

7. The substrate according to any one of the preceding claims, wherein the coating comprises an additional cover layer which is disposed above the hard material layer, preferably a cover layer made of nitrides, oxides, carbides, carbonitrides and/or oxynitrides selected from the group of elements aluminum, silicon, boron, zirconium, titanium, or carbon; and/or wherein an adhesion promoting layer is disposed between the substrate and the hard material layer, preferably an adhesion promoting layer formed of nitrides, oxides, carbides, carbonitrides and/or oxynitrides selected from the group of elements aluminum, silicon, boron, zirconium, titanium, nickel, chromium, or carbon; and/or wherein the substrate has decorated areas, at least in sections thereof, wherein the decorated areas are disposed between the substrate and the coating.

8. The substrate according to any one of the preceding claims, wherein the substrate is a glass ceramic having a coefficient of thermal expansion $\alpha_{20-300}$ of less than $2*10^{-6}$ $K^{-1}$.

9. The substrate according to any one of the preceding claims, wherein the coating is permanently resistant to temperatures of at least 300 °C, preferably at least 400°C; and/or wherein the coating exhibits a transmittance T of at least 50%, preferably at least 80% to light of wavelengths in the visible and/or infrared range.

10. A method for producing a scratch-resistant coating comprising a crystalline aluminum nitride containing hard material layer on a substrate according to any one of the preceding claims, comprising the steps of:

    a) providing a substrate in a sputtering apparatus that includes an aluminum containing target, wherein a glass ceramic substrate is provided as the substrate;
    b) releasing sputtered particles at a power density in a range from 8 to 1000 $W/cm^2$, preferably from 10 to 100 $W/cm^2$ per target surface, at final pressures of at most $2*10^{-5}$ mbar.

11. The method according to claim 10, wherein magnetron sputtering or high power impulse magnetron sputtering (HiPIMS) is employed as the sputtering method;
a negative voltage or an AC voltage is maintained between target and substrate;
coating is performed assisted by ion bombardment, preferably ion bombardment from an ion beam source, and/or by applying a voltage to the substrate; and/or the hard material layer is deposited on a substrate having a roughened or etched surface.

12. The method according to any one of claims 10 or 11, wherein an aluminum target doped with at least one of the elements silicon, boron, zirconium, titanium, nickel, chromium, or carbon is employed as the target; wherein the target preferably has an aluminum content of more than 50 wt%, more preferably of more than 60 wt%, and most preferably of more than 70 wt%.

13. The method according to any one of claims 10 to 12, wherein the substrate provided in step a) has a decorative layer and/or an adhesion promoting layer, preferably an adhesion promoting layer made of nitrides, oxides, carbides, carbonitrides and/or oxynitrides selected from the group of elements aluminum, silicon, boron, zirconium, titanium, nickel, chromium, or carbon.

14. The method according to any one of claims 10 to 13, wherein in a step following step b) a cover layer is applied onto the hard material layer, preferably a cover layer made of nitrides, oxides, carbides, carbonitrides and/or oxynitrides selected from the group of elements aluminum, silicon, boron, zirconium, titanium, nickel, or carbon.

15. The method according to any one of the preceding claims 10 to 14, wherein in step b) the particles are deposited at final pressures in a range of less than $2*10^{-5}$ mbar, preferably in a range from $1*10^{-6}$ to $5*10^{-6}$ mbar; and/or wherein the proportion of nitrogen in the total flow is at least 30 vol%, preferably at least 40 vol%, and more preferably at least 50 vol%.

16. Use of a coated substrate according to any one of claims 1 to 9 as an optical component, a cooktop panel, a display or a viewing window in the automotive sector, a watch glass, a fireplace window, an oven window, a glass or glass ceramic component in household appliances, or as a display, for example for tablet PCs or cell phones, especially as a touch display.

## Revendications

1. Substrat doté d'un revêtement destiné à augmenter la résistance aux rayures, dans lequel le revêtement comprend au moins une couche de matière dure transparente à haute réfringence, dans lequel la couche de matière dure contient du nitrure d'aluminium cristallin et dans lequel le nitrure d'aluminium présente une structure cristalline hexagonale ayant une orientation préférée (001) de symétrie hexagonale prépondérante et le substrat est une vitrocéramique.

2. Substrat selon la revendication 1, dans lequel la fraction de la structure cristalline ayant une orientation préférée (001) $x_{(001)}$

$$x_{(001)} = I_{(001)} / (I_{(001)} + I_{(100)})$$

et/ou

$$y_{(001)} = I_{(001)} / (I_{(001)} + I_{(101)})$$

déterminée à l'aide d'une mesure XRD du revêtement, est supérieure à 0,5, de préférence supérieure à 0,6 et particulièrement préférentiellement supérieure à 0,75.

3. Substrat selon l'une des revendications précédentes, dans lequel le module E du revêtement pour une force d'essai de 10 mN est de 80 à 250 GPa, de préférence de 110 à 200 GPa et/ou le rapport entre la dureté et le module E est d'au moins 0,08, de préférence d'au moins 0,1 et particulièrement préférentiellement > 0,1.

4. Substrat selon l'une des revendications précédentes, dans lequel la taille moyenne des cristaux est d'au maximum 25 nm, de préférence d'au maximum 15 nm et particulièrement préférentiellement de 5 à 15 nm.

5. Substrat selon l'une des revendications précédentes, dans lequel le nitrure d'aluminium de la couche de matière dure est dopé avec un ou plusieurs nitrures, carbures et/ou carbonitrures choisis dans le groupe des éléments silicium, bore, zircon, titane, nickel, chrome ou carbone et la teneur en aluminium dans la couche de matière dure par rapport à la matière dopée est de préférence supérieure à 50 % en poids, particulièrement préférentiellement supérieure à 60 % en poids et tout particulièrement préférentiellement supérieure à 70 % en poids.

6. Substrat selon l'une des revendications précédentes, dans lequel la fraction d'oxygène dans la couche de matière dure est d'au maximum 10% atomique, de préférence inférieure à 5 % atomique et particulièrement préférentiellement inférieure à 2 % atomique.

7. Substrat selon l'une des revendications précédentes, dans lequel le revêtement présente une couche de recouvrement supplémentaire, de préférence une couche de recouvrement en nitrures, oxydes, carbures, carbonitrures et/ou oxynitrures choisis dans le groupe des éléments aluminium, silicium, bore, zircon, titane ou carbone, qui est disposée au-dessus de la couche de matière dure et/ou entre le substrat et la couche de matière dure, une couche d'agent d'adhérence, de préférence une couche d'agent d'adhérence formée en nitrures, oxydes, carbures, carbonitrures et/ou oxynitrures choisis dans le groupe des éléments aluminium, silicium, bore, zircon, titane ou carbone, et/ou le substrat présente au moins des zones décorées partiellement, dans lequel les zones décorées partiellement sont disposées entre le substrat et le revêtement.

8. Substrat selon l'une des revendications précédentes, le substrat étant une vitrocéramique ayant un coefficient de dilatation thermique $\alpha_{20-300}$ inférieur à $2*10^{-6} K^{-1}$.

9. Substrat selon l'une des revendications précédentes, dans lequel le revêtement est durablement stable vis-à-vis de températures d'au moins 300°C, de préférence d'au moins 400°C et/ou le revêtement pour la lumière ayant des longueurs d'ondes dans le domaine visible et/ou infrarouge présente une transparence T d'au moins 50 %, de préférence d'au moins 80%.

10. Procédé de fabrication d'un revêtement résistant aux rayures ayant une couche de matière dure contenant du nitrure d'aluminium cristallin sur un substrat selon l'une des revendications précédentes, comprenant les étapes suivantes :

a) mise à disposition d'un substrat dans un dispositif de pulvérisation ayant une cible contenant de l'aluminium, un substrat en vitrocéramique étant mis à disposition en tant que substrat,
b) émission de particules pulvérisées à une densité de puissance dans la plage de 8 à 1000 W/cm$^2$, de préférence 10 à 100 W/cm$^2$ par surface cible, à partir de pressions finales d'au maximum 2*10$^{-5}$ mbar.

11. Procédé selon la revendication 10, dans lequel, comme procédé de pulvérisation, la pulvérisation magnétron ou le procédé HiPIMS (pulvérisation magnétron à impulsions haute puissance) est utilisé,
une tension négative ou une tension alternative entre cible et substrat est maintenue,
le revêtement s'effectue à l'aide du bombardement ionique, de préférence du bombardement ionique à partir d'une source de rayons ioniques et/ou par application d'une tension sur le substrat et/ou la couche de matière dure est déposée sur un substrat dont la surface a été rendue rugueuse ou a été gravée.

12. Procédé selon l'une des revendications 10 et 11, dans lequel, comme cible, une cible en aluminium ayant un dopage par au moins l'un des éléments silicium, bore, zircon, titane, nickel, chrome ou carbone est utilisée, dans lequel la cible présente de préférence une teneur en aluminium supérieure à 50 % en poids, particulièrement préférentiellement supérieure à 60 % en poids et tout particulièrement préférentiellement supérieure à 70 % en poids.

13. Procédé selon l'une des revendications 10 à 12, dans lequel le substrat mis à disposition à l'étape a) présente une couche de décor et/ou une couche d'agent d'adhérence, de préférence une couche d'agent d'adhérence en nitrures, oxydes, carbures, carbonitrures et/ou oxy-nitrures choisis dans le groupe des éléments aluminium, silicium, bore, zircon, titane, nickel, chrome ou carbone.

14. Procédé selon l'une des revendications 10 à 13, dans lequel, au cours d'une étape suivant l'étape b), une couche de recouvrement, de préférence une couche de recouvrement en nitrures, oxydes, carbures, carbonitrures et/ou oxynitrures, choisis dans le groupe des éléments aluminium, silicium, bore, zircon, titane, nickel, chrome ou carbone, est déposée sur la couche de matière dure.

15. Procédé selon l'une des revendications précédentes 10 à 14, dans lequel les particules à l'étape b) sont déposées à des pressions finales dans la plage inférieure à 2*10$^{-5}$ mbar, de préférence de 1*10$^{-6}$ mbar à 5*10$^{-6}$ mbar, et/ou la fraction d'azote sur le débit total est d'au moins 30 % en volume, de préférence d'au moins 40 % en volume et particulièrement préférentiellement d'au moins 50 % en volume.

16. Utilisation d'un substrat revêtu selon l'une des revendications 1 à 9 comme composant optique, plaque de cuisson, écrans ou vitrages dans le domaine automobile, verres de montre, parois vitrées de four, composants en verre ou vitrocéramique dans des appareils électroménagers ou comme écran par exemple pour des tablettes ou des téléphones mobiles, en particulier comme écran tactile.

Fig. 1:

Fig. 2:

Fig. 3:

Fig. 4:

Fig. 5:

Fig. 6:

a)

b)

Fig. 7:

Fig. 8:

Fig. 9:

a)

b)

c)

Fig. 10:

a)

b)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• DE 102011081234 A1

**In der Beschreibung aufgeführte Nicht-Patentliteratur**

• **E. LEWIN et al.** *Surface and Coatings Technology,* 2013, vol. 232, 680-689

• **A. PELISSON et al.** *Surface and coatings Technology,* 2007, vol. 202, 884-889